(19) Europäisches Patentamt

European Patent Office

Office européen des brevets

(11) Numéro de publication : **0 453 370 A1**

(12)

# DEMANDE DE BREVET EUROPEEN

(21) Numéro de dépôt : 91401034.3

(22) Date de dépôt : 18.04.91

(51) Int. Cl.⁵ : **H05K 13/02, H05K 13/04**

(30) Priorité : 20.04.90 FR 9005075

(43) Date de publication de la demande :
**23.10.91 Bulletin 91/43**

(84) Etats contractants désignés :
**AT BE CH DE DK ES GB IT LI NL SE**

(71) Demandeur : **EUROSOFT ROBOTIQUE**
**Route de Cholet**
**F-85620 Rocheservière (FR)**

(72) Inventeur : **Chataigner, Gabriel**
**3, Cité des Bruyères**
**F-85620 Rocheservière (FR)**
Inventeur : **Mouette, Didier**
**5, avenue Louise Michel**
**F-44400 Nantes (FR)**
Inventeur : **Mouton, Bernard**
**Rue de Joutelle**
**F-44140 Montbert (FR)**

(74) Mandataire : **Fort, Jacques**
**CABINET PLASSERAUD 84, rue d'Amsterdam**
**F-75009 Paris (FR)**

(54) **Chargeur de composants pour machine de pose automatique de composants électroniques et procédé de repérage et d'identification d'un tel chargeur.**

㊄ Le chargeur, destiné à une machine automatique de mise en place de composants sur un substrat est placé côte-à-côte avec d'autres chargeurs sur la machine. Il comprend un boîtier définissant un volume de stockage de composants de nature déterminée et de guidage de ces composants un à un vers un emplacement de prélèvement par une tête, ayant une face avant munie de moyens d'indication de position à la tête et ayant des moyens de mémorisation et d'identification de la nature du chargeur et des composants qu'il contient, capables de répondre à une interrogation en transmettant les données d'identification vers un bus de liaison avec un calculateur de la machine.

EP 0 453 370 A1

FIG.1.

16
18
12
X
40
14
10
43
34
24
26

L'invention a pour objet un chargeur de stockage et de distribution de composants électroniques pour machine automatique de mise en place de tels composants sur un substrat, généralement un circuit imprimé. Un tel chargeur est destiné à être placé, côte-à-côte avec d'autres chargeurs contenant des composants d'autre nature, répartis le long du trajet de circulation d'une tête de prélèvement de composants.

On connaît de nombreux types de chargeurs différents, définissant un volume de stockage de composant de nature déterminée et de guidage de chaque composant à son tour vers un emplacement de prélèvement, ayant une position déterminée dans le chargeur.

Sur les machines automatiques de pose utilisées à l'heure actuelle, une position individuelle bien déterminée est affectée au chargeur contenant un composant déterminé. La tête de prélèvement du composant est commandée par un programme qui l'amène successivement en tous les emplacements de prélèvement ainsi déterminés à l'avance.

Cette constitution a de nombreux inconvénients. La position du chargeur contenant les composants d'une nature déterminée est figée et l'opérateur de la machine ne peut pas changer la disposition des chargeurs sans modifier le programme d'assemblage des composants sur les substrats, et notamment le programme de commande de la tête. L'emplacement du chargeur doit être défini exactement, de sorte que des moyens de guidage et d'indexage précis sont nécessaires si les chargeurs sont amovibles. Dans la pratique, l'utilisation de moyens de guidage mécanique exige de prévoir un pas fixe de répartition des chargeurs successifs. Or, les chargeurs ont souvent un encombrement différent dans la direction de répartition. En conséquence, l'espace disponible pour y loger des chargeurs ne peut être pleinement utilisé. Enfin, toute erreur de l'opérateur dans la mise en place des chargeurs provoque des erreurs dans le montage des composants sur le substrat.

On connaît également (EP-A-360 985) un dispositif de prélèvement de composants alimenté par des bandes provenant d'un chargeur. Chaque composant peut porter un code d'identification. Une caméra permet de reconnaître les composants prélevés suivant leur forme ou leur code. Il n'y a pas de moyens de mémorisation et d'identification actifs, capables de répondre à une interrogation en transmettant des données d'identification vers un bus.

On connaît également (DE 3 704 414) un dispositif d'alimentation de cassettes portant, sur une face externe, un code barre ou un code magnétique : il s'agit là encore de moyens purement passifs.

L'invention vise à fournir un chargeur de composants répondant mieux que ceux antérieurement connus aux exigences de la pratique, notamment en ce que sa position sur la machine n'est pas imposée.

Dans ce but, l'invention propose notamment un chargeur de stockage et de distribution de composants pour machine automatique de mise en place de composants sur un substrat, destiné à être placé côte-à-côte avec d'autres chargeurs sur la machine, comprenant un boîtier définissant un volume de stockage de composants de nature déterminée et de guidage de ces composants un à un vers un emplacement de prélèvement par une tête, ayant une face avant munie de moyens d'indication de position repérables par la tête et ayant des moyens de mémorisation et d'identification de la nature du chargeur et des composants qu'il contient, capables de répondre à une interrogation en transmettant les données d'identification vers un bus de liaison de la machine.

On voit que le chargeur porte des moyens de mémorisation et d'identification de la nature du chargeur et des composants qu'il contient, capables de répondre à une interrogation provenant de la machine en transmettant des données d'identification vers un bus de liaison avec un calculateur de la machine.

Les moyens de mémorisation peuvent notamment être constitués par une mémoire programmable non volatile (mémoire morte programmable et effaçable électriquement par exemple) munie de moyens réagissant à une interrogation par l'envoi desdites données d'identification suivant un protocole déterminé, par exemple un protocole série tel que RS 232.

Les moyens de mémorisation peuvent être prévus pour être programmables à l'avance, sur un poste extérieur à la machine et/ou pour être programmables à l'aide d'un calculateur équipant la machine elle-même.

L'invention vise également à fournir un procédé de repérage et d'identification de chargeur placé sur une machine automatique de mise en place de composants électroniques, permettant l'identification du chargeur et de son contenu quelle que soit la position dans laquelle il a été placé sur la machine.

Dans ce but, l'invention propose un procédé de repérage et d'identification d'un chargeur du type défini plus haut, placé sur une machine de pose ayant une tête de saisie déplaçable suivant un trajet qui la fait passer devant le chargeur, procédé suivant lequel le chargeur est détecté lors du passage de la tête devant lui, une interrogation d'identification est émise vers le chargeur en réponse à la détection et un message mémorisé d'identification du chargeur est émis par ce dernier en réponse à la demande, sur un bus de liaison appartenant à la machine.

L'invention sera mieux comprise à la lecture de la description qui suit d'un mode particulier de réalisation de l'invention, donné à titre d'exemple non limitatif. La description se réfère aux dessins qui l'accompagnent, dans lesquels :

    – la Figure 1 est un schéma de principe, en perspective, montrant la position relative d'un chargeur et d'une tête de machine de pose, lors de la détection du chargeur par la tête ;

– la Figure 2 est un schéma synoptique de principe montrant les constituants électriques et électroniques principaux équipant le chargeur et ceux qui coopèrent avec ces composants ;

– la Figure 3 montre l'allure des signaux de détection ;

– la Figure 4 montre schématiquement un chariot pouvant porter plusieurs chargeurs.

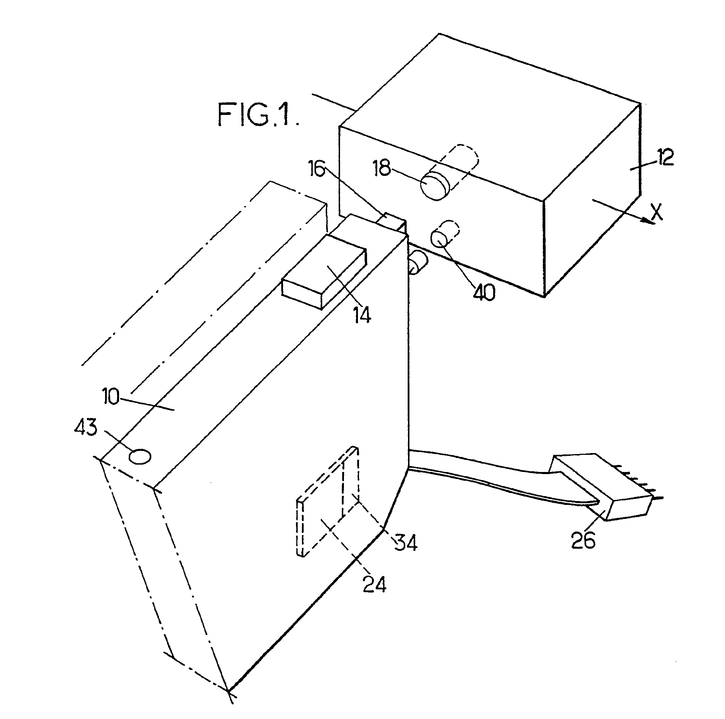

Le chargeur 10 montré schématiquement sur la Figure 1 est destiné à être placé sur le châssis d'une machine de pose de composants, face à un trajet parcouru par une tête de saisie et de pose 12, dont la constitution peut être du genre décrit dans la demande de brevet français n° 90 05076. La machine peut par exemple comporter un rail (non représenté), parallèle au trajet de la tête, sur lequel le chargeur 10 peut être placé à un endroit quelconque. Le chargeur 10 comporte un boîtier contenant des composants successifs, tous identiques, et il est prévu pour amener ces composants successivement en un emplacement déterminé 14 du chargeur, accessible par la tête 12. D'autres chargeurs peuvent être placés le long du rail, à des endroits quelconques, tels que celui montré en traits mixtes sur la Figure 1.

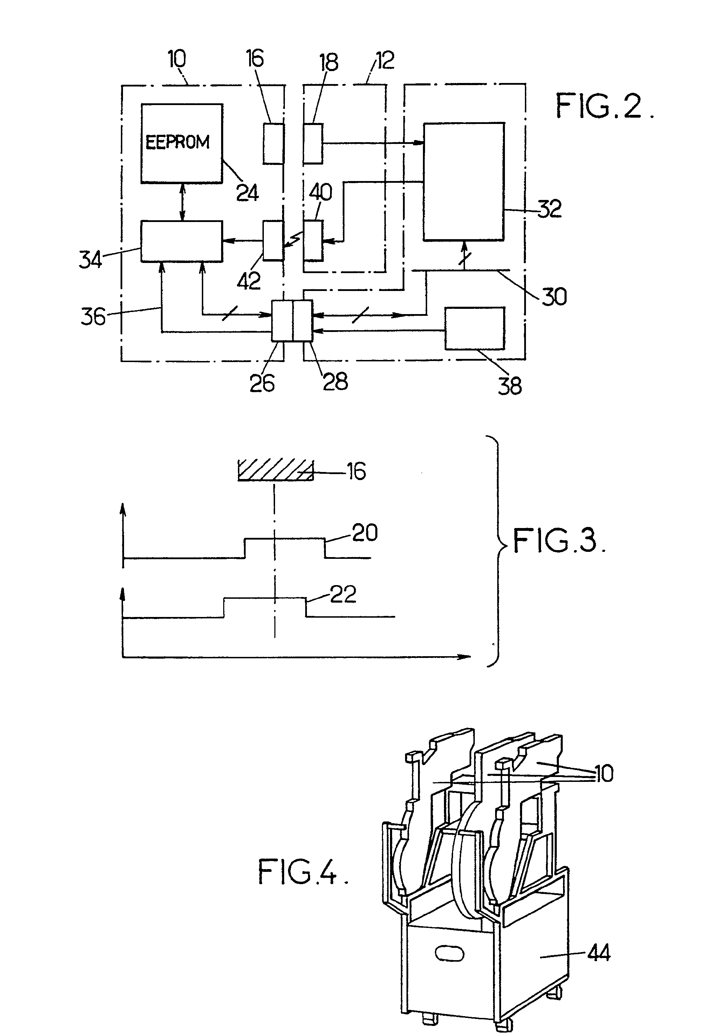

Le chargeur 10 et la tête 12 ont des moyens de repérage et de localisation du chargeur. Ces moyens peuvent notamment comporter un plot magnétique 16 fixé à la face avant du boîtier du chargeur, constituant un moyen d'indication de position, et un capteur 18, tel qu'un interrupteur à lame souple ou ILS, porté par la tête et qui vient passer devant le plot 16 lors du déplacement de la tête. Suivant que la tête circule dans un sens ou dans l'autre suivant la direction X, le signal obtenu au passage devant le plot 16 présente, en fonction de X, la forme 20 ou 22 montrée sur la Figure 3, du fait de l'hystérésis du capteur. Mais la position exacte du plot 16, placé en face du capteur, peut être obtenue en faisant la moyenne des signaux 20 et 22, à l'aide d'un aller-retour de la tête sur tout son trajet.

Pour éviter le phénomène d'hystérésis, on peut utiliser des moyens d'indication de position de nature différente de ceux qui viennent d'être décrits. On peut par exemple utiliser un générateur de faisceau optique guidé, tel qu'une diode électroluminescente munie d'une lentille de focalisation, et un capteur de lumière, tel qu'une photodiode.

Le chargeur 10 contient des moyens de mémorisation contenant des données d'identification de la nature du chargeur, d'identification des composants qu'il contient et, éventuellement, des données concernant d'autres paramètres de fonctionnement. Ces moyens de mémorisation peuvent être constitués par une mémoire numérique non volatile 24. Cette mémoire est reliée à un connecteur 26 enfichable sur un connecteur complémentaire 28 (Figure 2), soit manuellement, soit automatiquement lors de l'amenée du chargeur contre le rail de la machine. Le connecteur 28 est relié à un bus 30 de liaison avec un calculateur central 32 de gestion du fonctionnement de la machine. Dans le mode de réalisation montré en Figure 2, la mémoire 24 est équipée d'un coupleur 34, éventuellement à microprocesseur, destiné à gérer les transferts d'informations entre la mémoire 24 et le calculateur 32 suivant un protocole de nature classique, tel qu'un protocole d'échange série RS 232. La mémoire non volatile 24 peut notamment être une mémoire morte à écriture et effacement électrique, permettant de modifier le contenu de la mémoire par des commandes provenant du calculateur 32 lorsque le chargeur 10 est monté sur la machine. Cette réalisation n'est cependant pas la seule possible : on pourrait également utiliser une mémoire morte programmable uniquement à l'avance et non effaçable.

L'énergie électrique nécessaire au fonctionnement d'une mémoire morte à écriture et effacement électrique et du coupleur 26 peut être fournie par une ligne 36 raccordée au connecteur 28. Le connecteur 28 comprend de son côté un contact de liaison avec une source d'alimentation 38 portée par la machine.

Les données contenues dans la mémoire 24 sont transmises à la machine en réponse à une interrogation, provoquée par la détection du plot 16. Dans le mode de réalisation montré en Figure 2, le signal de détection est envoyé par le capteur 18 de la tête 12 au calculateur 32 et celui-ci émet un ordre d'interrogation codée vers un émetteur, alors que ce dernier est en face d'un récepteur 42 porté par le chargeur. Le transfert de l'interrogation peut s'effectuer par voie optique, l'émetteur 40 étant alors une diode électroluminescente ou LED et le récepteur une photodiode ou un phototransistor. Le signal d'interrogation peut être par exemple constitué par un signal d'horloge, à fréquence déterminée, commandant la fréquence de fonctionnement du coupleur 34. L'émetteur et le récepteur peuvent cependant être d'autre nature. Ils peuvent même être supprimés, l'interrogation se faisant alors, à partir du calculateur 32, par envoi d'une interrogation sur le bus 30, ce qui implique que chaque chargeur ait une adresse particulière mémorisée à l'avance dans le calculateur 32.

Si la machine ne trouve pas le chargeur d'un composant particulier éventuellement enlevé par l'opérateur pour rechargement de celui-ci, elle continue à poser les autres composants. Si l'opérateur replace le chargeur à son emplacement précédent, la machine qui a conservé les coordonnées de celui-ci en mémoire prend les composants en question.

Dans le cas contraire, si l'opérateur replace le chargeur à un autre endroit avec des coordonnées différentes, le calculateur central 32 interroge zone par zone pour déterminer si les références du composant sont dans l'une d'entre elles. Après identification de la zone, la tête interroge, comme indiqué succédemment, tous les chargeurs de la zone identifiée.

Le boîtier du chargeur 10 porte avantageusement un voyant 43 ou plusieurs. Un tel voyant permet de fournir à l'opérateur de la machine une information, telle que par exemple :

- une alarme en cas de panne ou d'épuisement des composants contenus ;
- une indication de fonctionnement, indiquant à l'opérateur quels sont les chargeurs qui seront utilisés par la machine lors de l'assemblage sur les circuits imprimés.

La mémoire 24 peut être prévue pour recevoir des indications permanentes, destinées à identifier le chargeur et/ou les composants qu'il contient et des informations modifiables au cours du fonctionnement.

Les informations permanentes, utilisées pendant toute la période d'emploi du chargeur, peuvent notamment être constituées par :

- un code d'identification du chargeur (indiquant par exemple sa nature, son encombrement le long de l'axe X, etc.) et un code indiquant la nature des composants contenus et les caractéristiques de conditionnement du composant, qui peuvent elles mêmes imposer d'apporter des corrections aux éléments de préhension de la tête ou à la machine de pose elle-même.

Les informations modifiables peuvent indiquer les incidents survenus au cours de la vie du chargeur et l'évolution du chargeur dans le temps : en particulier, la mémoire peut être modifiée au cours de l'utilisation du chargeur par des informations transmises par le calculateur 32 ou provenant de capteurs placés dans le chargeur lui-même indiquant le nombre de cycles effectués, le taux de pannes, le nombre de composants stockés reconnus défectueux en cours de montage, etc.

Elles peuvent également contenir des informations de corrections des coordonnées de pose du composant selon les axes X, Y et Z pour corriger les décalages mécaniques constants et les erreurs temporaires telles que les tolérances du conditionnement.

Le procédé de mise en oeuvre d'un tel chargeur peut notamment être le suivant, une fois que ce chargeur a été placé sur la machine, en même temps que d'autres (qui seront ou non utilisés, suivant le type de circuit à réaliser).

Au cours d'une phase de localisation et d'identification, la tête de la machine est mise en mouvement pour lui faire parcourir la totalité de son trajet disponible suivant la direction X. Elle passe ainsi successivement devant tous les chargeurs. Chaque fois qu'elle arrive au droit d'un chargeur, le capteur 18 fournit un signal qui provoque un échange d'informations entre la mémoire 24 contenue dans le chargeur et le calculateur central : ainsi, la machine connaît finalement l'identité de chaque chargeur mis en place, son emplacement et la référence des composants contenus. A la fin de cette phase, et d'une phase de retour qui permet de localiser de façon précise chaque chargeur et, éventuellement, de vérifier les informations recueillies lors du déplacement aller, la machine connaît toutes les informations qui sont nécessaires à son fonctionnement. Elle peut ainsi, en utilisant les informations qu'elle contient en mémoire, et notamment le programme de pose des composants, détecter les erreurs de l'opérateur (par exemple oubli de mise en place d'un chargeur nécessaire).

Comme on l'a indiqué plus haut, l'écriture en mémoire du chargeur peut se faire soit sur la machine à l'aide du calculateur qui l'équipe, soit avant mise en place des chargeurs, soit encore à l'aide d'un terminal de programmation relié au bus, au moment de la préparation du programme de pose que doit exécuter la machine.

Le chargeur ou plusieurs chargeurs peuvent être portés par un chariot permettant d'amener le chargeur contre la machine et de le remplacer par un autre. La Figure 4 montre, de façon schématique, trois chargeurs 10 portés par un même chariot de transport, prévu pour que tous les emplacements de saisie se trouvent au même niveau, et à la même distance du rail de la machine, même dans le cas de chargeurs qui diffèrent par leur encombrement ou par leur développement le long de la direction X. Le chariot 44 peut être porté par des roues pour faciliter l'approche et l'enlèvement. Etant donné que la position à donner au chargeur le long du rail est indifférente, il n'est pas nécessaire de placer les chargeurs sur le chariot dans une position bien déterminée et il n'est pas non plus nécessaire de munir le chariot de moyens d'alignement avec la machine dans une position bien déterminée.

Le chargeur peut être prévu de façon à permettre sa recherche alors qu'il est placé sur un plan de stockage situé à côté de la machine, afin que cette dernière puisse y prélever des composants.

## Revendications

1. Chargeur de stockage et de distribution de composants pour machine automatique de mise en place de composants sur un substrat, destiné à être placé côte-à-côte avec d'autres chargeurs sur la machine, comprenant un boîtier définissant un volume de stockage de composants de nature déterminée et de guidage de ces composants un à un vers un emplacement de prélèvement par une tête (12), ayant une face avant munie de moyens (16) d'indication de position à la tête (12) et ayant des moyens (24) de mémorisation et d'identification de la nature du chargeur et des composants qu'il contient, capables de répondre à une interrogation en transmettant les données d'identification vers un bus (30) de liaison avec un calculateur (32) de la machine.

2. Chargeur selon la revendication 1, caractérisé en ce que les moyens de mémorisation sont constitués par une mémoire programmable non volatile (24) munie de moyens réagissant à une interrogation par l'envoi desdites données d'identification, suivant un protocole déterminé.

3. Chargeur selon la revendication 1 ou 2, caractérisé en ce que les moyens de mémorisation sont programmables à l'avance ou par l'intermédiaire du bus de liaison.

4. Chargeur selon l'une quelconque des revendications précédentes, caractérisé en ce que les données mémorisées comportent une identification individuelle du chargeur et de son mode de fonctionnement et une référence indiquant le composant qu'il contient.

5. Chargeur selon la revendication 4, caractérisé en ce que les moyens de mémorisation contiennent également des informations de correction de la machine et des informations portant sur la vie du chargeur, telles que le nombre de cycles effectués par le chargeur et le taux de pannes.

6. Chargeur selon l'une quelconque des revendications précédentes, caractérisé en ce que les moyens de mémorisation comportent un coupleur de liaison avec le calculateur mettant en oeuvre un protocole déterminé.

7. Chargeur selon l'une quelconque des revendications précédentes, caractérisé en ce qu'il comprend, sur sa face avant, un récepteur de code d'interrogation émis par un émetteur porté par la machine.

8. Chargeur selon l'une quelconque des revendications précédentes, caractérisé en ce qu'il comporte un connecteur (26) enfichable sur un connecteur complémentaire de la machine et destiné à transmettre un code d'interrogation auxdits moyens de mémorisation et à transférer vers la machine les données d'identification.

9. Chargeur selon la revendication 8, caractérisé en ce que le connecteur comporte au moins un contact de transmission d'énergie électrique de la machine vers le chargeur.

10. Procédé de repérage et d'identification d'un chargeur suivant l'une quelconque des revendications précédentes, placé sur une machine de pose ayant une tête de saisie déplaçable suivant un trajet qui la fait passer devant le chargeur, procédé suivant lequel le chargeur est détecté lors du passage de la tête devant lui, une interrogation d'identification est émise vers le chargeur en réponse à la détection et un message mémorisé d'identification du chargeur est émis par ce dernier en réponse à la demande, sur un bus de liaison appartenant à la machine.

FIG.1.

FIG.2.

FIG.3.

FIG.4.

Office européen
des brevets

**RAPPORT DE RECHERCHE EUROPEENNE**

Numero de la demande

EP    91 40 1034

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| D,X | EP-A-360985 (MATSUSHITA ELECTRIC INDUSTRIAL CO.) * colonne 4, ligne 50 - colonne 6, ligne 8 * | 1, 10 | H05K13/02 H05K13/04 |
| A | * colonne 7, ligne 21 - colonne 9, ligne 31; revendications 1, 5, 7; figures 1, 2, 5-9 * | 2, 4 | |
| | --- | | |
| D,X | DE-A-3704414 (SIEMENS AKTIENGESELLSCHAFT) * colonne 4, lignes 51 - 59 * | 1 | |
| A | * colonne 5, ligne 35 - colonne 6, ligne 15; revendications 1, 7, 8; figures 1, 2 * | 4, 5 | |
| | --- | | |
| A | US-A-4754545 (ELLIOTT) * revendication 1 * | 1 | |
| | --- | | |
| A | DE-A-3919636 (TDK) * colonne 6, lignes 6 - 23; figures 1-3 * | 1 | |
| | ----- | | |

**DOMAINES TECHNIQUES RECHERCHES (Int. Cl.5)**

H05K

Le présent rapport a été établi pour toutes les revendications

| Lieu de la recherche | Date d'achèvement de la recherche | Examinateur |
|---|---|---|
| LA HAYE | 19 JUILLET 1991 | RIEUTORT A.S. |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons

......................................................................................
& : membre de la même famille, document correspondant

EPO FORM 1503 03.82 (P0402)